# EUROPÄISCHE PATENTANMELDUNG

(11) **EP 4 310 220 A1**
(43) Veröffentlichungstag der Anmeldung: **24.01.2024**
(21) Anmeldenummer: 23184147.9
(22) Anmeldetag: 07.07.2023
(51) Int. Cl.: C23C 14/24, C23C 14/26, C23C 14/54, C23C 14/56

(54) **VERFAHREN UND DAMPFVERTEILUNGSVORRICHTUNG**

(30) Priorität: 22.07.2022 DE 102022118437
(71) Anmelder: VON ARDENNE Asset GmbH & Co. KG, 01328 Dresden (DE)
(72) Erfinder: HEIMKE, Bruno, 01277 Dresden (DE); RANK, Rolf, 01139 Dresden (DE); KARN, Christian, 01257 Dresden (DE)
(74) Vertreter: Viering, Jentschura & Partner mbB Patent- und Rechtsanwälte

(57) **Zusammenfassung**

Gemäß verschiedenen Ausführungsformen kann ein Verfahren (400) aufweisen: Ermitteln (401) einer Angabe, die eine räumliche Verteilung eines Materialdampfstroms, welcher von einer Vielzahl von Emissionsdüsen (106a) emittiert wird, repräsentiert; Ansteuern (403) eines Stellglieds (404), welches eingerichtet ist, einen Gasstrom, der dem Materialdampfstrom überlagert wird, zu beeinflussen, basierend auf

## Beschreibung

Verschiedene Ausführungsbeispiele betreffen ein Verfahren und eine Dampfverteilungsvorrichtung.

Im Allgemeinen kann ein Substrat, beispielsweise ein Glassubstrat beschichtet werden, so dass die chemischen und/oder physikalischen Eigenschaften des Substrats verändert werden können. Ein Beschichtungsprozess kann beispielsweise erfolgen, indem ein zu verdampfendes Material (auch als Verdampfungsgut oder Beschichtungsmaterial bezeichnet) thermisch verdampft wird, und der so gebildete Dampf auf dem Substrat abgeschieden wird. Dazu kann ein so genannter Linearverdampfer eingesetzt werden, welcher eine Vielzahl von Düsen aufweist, die den Dampf in Richtung des Substrats abgeben.

Eine häufig genutzte Konfiguration ist der sogenannte Linearverdampfer, bei dem das Verdampfungsgut in ein Rohr geführt wird, welches eine Reihe von Emissionsdüsen aufweist, aus denen das Verdampfungsgut als Materialdampfstrom austritt.

Gemäß verschiedenen Ausführungsformen wurde erkannt, dass die räumliche Verteilung, mit welcher der Materialdampfstrom aus einer solchen Reihe von Emissionsdüsen (auch als Düsenreihe bezeichnet) austritt, Störungen unterworfen ist, beispielsweise aufgrund von Schwankungen der Eigenschaften der Emissionsdüsen, strömungsbedingten Schwankungen im Rohr, der endlichen Rohrlänge und dergleichen. Dadurch kann es zu einer ungleichmäßigen Beschichtung (beispielsweise einer Schichtinhomogenität) kommen, speziell am Rand der Beschichtung (bei z.B. variierenden Abstand zum Substrat, verschiedene Substratdicken, Wechsel des Verdampfungsmaterials). Diesen Störungen kann herkömmlicherweise nur durch Austausch der betreffenden Emissionsdüse(n) begegnet werden, was allerdings nur erfolgen kann, wenn der Beschichtungsprozess unterbrochen wird. Ferner kann es erforderlich sein, einen solchen Austausch zu wiederholen, beispielsweise wenn das Beschichtungsmaterial gewechselt wird oder eine andere Einstellung geändert wird.

Gemäß verschiedenen Ausführungsformen werden ein Verfahren und eine Dampfverteilungsvorrichtung (beispielsweise einen Linearverdampfer aufweisend) bereitgestellt, die es vereinfachen, diesen Störungen zu begegnen. Dadurch wird insbesondere erleichtert, den ablaufenden Beschichtungsprozess zu beeinflussen, beispielsweise während des Beschichtungsprozesses eine Schichtinhomogenität während des Beschichtungsprozesses zu verringern oder deren Entstehung sogar zu hemmen.

Gemäß verschiedenen Ausführungsformen erfolgt der Beschichtungsprozess mittels thermischen Verdampfens und mittels eines Linearverdampfers auf einem (z.B. großen) Substrat, bei dem der Linearverdampfer beispielsweise genau eine Düsenreihe aufweist, mit deren Hilfe das Verdampfungsgut dampfförmig homogen auf das Substrat verteilt wird.

Es zeigen
- Figur 1, 2 und 3: jeweils eine Dampfverteilungsvorrichtung gemäß verschiedenen Ausführungsformen verschiedenen schematischen Ansichten;
- Figur 4: ein Verfahren gemäß verschiedenen Ausführungsformen in einem schematischen Ablaufdiagramm;
- Figur 5, 6, 7 und 8: jeweils eine Dampfverteilungsvorrichtung gemäß verschiedenen Ausführungsformen verschiedenen schematischen Ansichten; und
- Figur 9 und 10: jeweils ein Verfahren gemäß verschiedenen Ausführungsformen in einem schematischen Ablaufdiagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Als Ist-Zustand einer Entität (z.B. einer Vorrichtung, eines Systems oder eines Prozesses) kann der tatsächlich vorliegende bzw. sensorisch erfassbare Zustand der Entität verstanden werden. Als Soll-Zustand der Entität kann der angestrebte Zustand, d.h. eine Vorgabe, verstanden werden. Als Steuern kann eine beabsichtigte Beeinflussung des momentanen Zustands (auch als Ist-Zustand bezeichnet) der Entität verstanden werden. Dabei kann der momentane Zustand gemäß der Vorgabe (auch als Soll-Zustand bezeichnet) verändert werden, z.B. indem ein oder mehr als ein Betriebsparameter (dann auch als Stellgröße bezeichnet) der Entität verändert wird, z.B. mittels eines Stellglieds. Regeln kann als Steuern verstanden werden, wobei zusätzlich einer Zustandsänderung durch Störungen entgegengewirkt wird. Dazu wird der Ist-Zustand mit dem Soll-Zustand verglichen und die Entität derart beeinflusst, z.B. mittels eines Stellglieds, dass die Abweichung des Ist-Zustands von dem Soll-Zustand minimiert wird. Die Regelung implementiert somit im Gegensatz zu der reinen vorwärts gerichteten Ablaufsteuerung eine fortlaufende Einflussnahme der Ausgangsgröße auf die Eingangsgröße, welche durch den sogenannten Regelkreis bewirkt wird (auch als Rückführung bezeichnet). Mit anderen Worten kann hierin verstanden werden, dass alternativ oder zusätzlich zu der Steuerung (bzw. dem Ansteuern) eine Regelung verwendet werden kann bzw. alternativ oder zusätzlich zu dem Steuern ein Regeln erfolgen kann.

Der Zustand einer steuerbaren Vorrichtung (z.B. einer Dampfverteilungsvorrichtung) bzw. eines steuerbaren Prozesses (z.B. Beschichtungsprozess) lässt sich als Punkt (auch als Arbeitspunkt oder Betriebspunkt bezeichnet) in einem Raum (auch als Zustandsraum bezeichnet) angeben, der von den veränderlichen Parametern der Vorrichtung bzw. des Vorgangs (auch als Betriebsparameter bezeichnet) aufgespannt wird. Der Zustand der Vorrichtung bzw. des Vorgangs ist somit eine Funktion des jeweiligen Werts eines oder mehr als eines Betriebsparameters, welcher den Zustand der Vorrichtung bzw. des Vorgangs somit repräsentiert. Der Ist-Zustand kann basierend auf einer Messung (z.B. mittels eines Messglieds, z.B. einem Sensor davon) eines oder mehr als eines Betriebsparameters (dann auch als Regelgröße bezeichnet) ermittelt werden.

Als Sensor (auch als Detektor bezeichnet) kann ein Wandler verstanden werden, der eingerichtet ist, eine zu dem Typ des Sensors korrespondierende Eigenschaft seiner Umgebung (z.B. qualitativ oder quantitativ) als Messgröße zu erfassen, z.B. eine physikalische Eigenschaft, eine chemische Eigenschaft und/oder eine stoffliche Beschaffenheit. Die Messgröße ist diejenige physikalische Größe, der die Messung mittels des Sensors gilt. Je nach Komplexität der zu messenden Umgebung des Sensors kann der Sensor eingerichtet sein, nur zwischen zwei Zuständen der Messgröße unterscheiden zu können (auch als Messschalter bezeichnet), zwischen mehr als zwei Zuständen der Messgröße unterscheiden zu können oder die Messgröße quantitativ zu erfassen. Ein Beispiel für eine quantitativ erfasste Messgröße ist beispielsweise ein Druck, dessen Ist-Zustand mittels des Sensors als Wert erfasst werden kann.

Ein Sensor kann Teil einer Messkette sein, welche eine entsprechende Infrastruktur (z.B. Prozessor, Speichermedium und/oder Bussystem und dergleichen aufweisend) aufweist. Die Messkette kann eingerichtet sein, den entsprechenden Sensor (z.B. Gassensor, Drucksensor und/oder Ratesensor) anzusteuern, dessen erfasste Messgröße als Eingangsgröße zu verarbeiten und darauf basierend ein elektrisches Signal als Ausgangsgröße bereitzustellen, welches die Eingangsgröße repräsentiert. Die Messkette kann beispielsweise mittels einer Steuervorrichtung implementiert sein oder werden.

Der Begriff "Steuervorrichtung" kann als jede Art einer Logik implementierenden Entität verstanden werden, die beispielsweise eine Verschaltung und/oder einen Prozessor aufweisen kann, welche beispielsweise Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein. Die Steuervorrichtung kann beispielsweise eine speicherprogrammierbare Steuervorrichtung (SPS) aufweisen oder daraus gebildet sein.

Gemäß verschiedenen Ausführungsformen kann ein Datenspeicher (allgemeiner auch als Speichermedium bezeichnet) ein nichtflüchtiger Datenspeicher sein. Der Datenspeicher kann beispielsweise eine Festplatte und/oder zumindest einen Halbleiterspeicher (wie z.B. Nur-Lese-Speicher, Direktzugriffsspeicher und/oder Flash-Speicher) aufweisen oder daraus gebildet sein. Der Nur-Lese-Speicher kann beispielsweise ein löschbarer programmierbarer Nur-Lese-Speicher (kann auch als EPROM bezeichnet werden) sein. Der Direktzugriffsspeicher kann ein nichtflüchtiger Direktzugriffsspeicher (kann auch als NVRAM -"non-volatile random access memory" bezeichnet werden) sein. Beispielsweise kann in dem Datenspeicher eines oder mehr als eines von Folgendem gespeichert werden: die Codesegmente, die das Verfahren repräsentieren, ein oder mehr als ein Soll-Zustand, eine oder mehr als eine Zeitabhängigkeit des Soll-Zustands, einen oder mehr als einen Parameter, der eine Geometrie repräsentiert, und dergleichen.

Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden, beispielsweise auch virtuelle Prozessoren (oder eine virtuelle Maschine) oder eine Vielzahl dezentraler Prozessoren, die beispielsweise mittels eines Netzwerks miteinander verbunden sind, beliebig räumlich verteilt sind und/oder beliebige Anteile an der Implementierung der jeweiligen Funktionen haben (z.B. Rechenlastverteilung unter den Prozessoren). Dasselbe gilt im Allgemeinen für eine anders implementierte Logik zur Implementierung der jeweiligen Funktionen. Es versteht sich, dass einer oder mehrere der hierin detailliert beschriebenen Verfahrensschritte von einem Prozessor ausgeführt (z.B. realisiert) werden können, durch eine oder mehrere spezifische Funktionen, die von dem Prozessor ausgeführt werden.

Der Begriff "Stellglied" (z.B. einen Aktuator bzw. Aktor aufweisend) kann als ein Wandler verstanden werden, der zum Beeinflussen eines Zustandes eines Prozesses (z.B. eines Beschichtungsprozesses) oder einer Vorrichtung in Antwort auf ein Ansteuern des Stellglieds eingerichtet ist. Das Stellglied kann ein diesem zugeführtes Signal (das sogenannte Ansteuern) in mechanische Bewegungen bzw. Veränderungen physikalischer Größen wie Druck, Gasfluss oder Temperatur umsetzen. Ein elektromechanisches Stellglied kann zum Beispiel eingerichtet sein, in Antwort auf das Ansteuern elektrische Energie in mechanische Energie (z.B. durch Bewegung) zu überführen.

Das Ansteuern eines Stellglieds kann mittels eines (z.B. elektrischen oder fluidmechanischen) Steuersignals (z.B. einer elektrischen Spannung) erfolgen, welche einem Steuereingang des Stellglieds zugeführt werden kann. Das Anlegen des fluidmechanischen Steuersignals kann mittels eines elektrisch steuerbaren Ventils erfolgen, d.h. welche mittels des elektrischen Steuersignals angesteuert werden kann. Das Erzeugen des elektrischen Steuersignals kann mittels der Steuervorrichtung (z.B. einem Signalgenerators davon) erfolgen. Das Stellglied kann beispielsweise eingerichtet sein, das Steuersignal in eine Wechselwirkung, welche eine Änderung des Ist-Zustandes bewirkt, zu überführen, z.B. mittels einer mechanischen Kraft, eines Magnetfelds oder dergleichen.

Eine System (z.B. Vakuumanordnung) kann eine oder mehr als eine Vakuumkammer und im betriebsbereiten Zustand ein Pumpensystem (aufweisend zumindest eine Grobvakuumpumpe und optional zumindest eine Hochvakuumpumpe) aufweisen, welches mit dem Inneren der Vakuumkammer (auch als Kammerinneres bezeichnet) fluidleitend gekoppelt ist. Gemäß verschiedenen Ausführungsformen kann die Vakuumkammer mittels eines Kammergehäuses bereitgestellt sein, das derart eingerichtet ist, dass in dem Kammerinneren ein Vakuum (d.h. ein Druck kleiner als 0,3 bar), z.B. eine Vakuumatmosphäre und/oder gemäß einem Soll-Druck, bereitgestellt werden kann. Das Pumpensystem kann eingerichtet sein, dem Kammerinneren ein Gas zu entziehen, so dass darin das Vakuum bereitgestellt sein oder werden kann, beispielsweise gemäß dem Soll-Druck.

Der Begriff "Vakuum" kann verstanden werden als einen Druck aufweisend von weniger als 0,3 bar, z.B. in einem Bereich von ungefähr 10 mbar (Millibar) bis ungefähr 1 mbar (mit anderen Worten Grobvakuum) oder weniger, z.B. in einem Bereich von ungefähr 1 mbar bis ungefähr 10⁻³ mbar (mit anderen Worten Feinvakuum) oder weniger, z.B. in einem Bereich von ungefähr 10⁻³ mbar bis ungefähr 10⁻⁷ mbar (mit anderen Worten Hochvakuum) oder weniger.

Gemäß verschiedenen Ausführungsformen wird auf ein sogenanntes Verdampfungsgut (auch als Beschichtungsmaterial oder zu verdampfendes Material bezeichnet, z.B. ein schichtbildendes Material) Bezug genommen, welches in verschiedene Aggregatzustände gebracht werden kann, beispielsweise von fest (Ausgangzustand) zu gasförmig und wieder zu fest (z.B. als Beschichtung). Der Übergang in den gasförmigen Aggregatzustand (vereinfacht auch als gasförmiger Zustand oder als Dampf bezeichnet), das sogenannte Vaporisieren, kann unmittelbar vom festen Zustand (einen Phasenübergang eines Feststoffs in den gasförmigen Aggregatzustand aufweisend) oder über den flüssigen Zustand (einen Phasenübergang einer Flüssigkeit in den gasförmigen Aggregatzustand aufweisend) des Verdampfungsguts erfolgen. Hierin wird für das Vaporisieren vereinfacht der Begriff "Verdampfen" verwendet, wobei damit auch ein Sieden, Verdunsten und/oder Sublimieren gemeint sein kann.

Die Dampfverteilungsvorrichtung kann Teil einer Verdampfungsvorrichtung sein, die ferner einen Tiegel aufweist zum Verdampfen des Beschichtungsmaterials.

Komponenten der Dampfverteilungsvorrichtung und/oder Verdampfungsvorrichtung (beispielsweise Dampfverteilungskanal, Düse(n) und/oder Tiegel), welche dem Verdampfungsgut ausgesetzt sind und/oder erwärmt werden, können gemäß verschiedenen Ausführungsformen (physisch und/oder chemisch) gegenüber dem Verdampfungsgut stabil sein, beispielsweise wenn diese auf eine Betriebstemperatur gebracht sind. Die Betriebstemperatur kann größer sein als eine Temperatur (auch als Gasübergangstemperatur bezeichnet), bei der das Verdampfungsgut in den gasförmigen Zustand übergeht (auch als Vaporisieren bezeichnet). Die Betriebstemperatur und/oder die Gasübergangstemperatur können beispielsweise größer sein als ungefähr 200°C, z.B. als ungefähr 400°C, z.B. als ungefähr 600°C, z.B. als ungefähr 800°C.

Komponenten der Dampfverteilungsvorrichtung und/oder Verdampfungsvorrichtung (beispielsweise Dampfverteilungskanal, Düse(n) und/oder Tiegel) können gemäß verschiedenen Ausführungsformen eine Keramik (z.B. Quarzglas, Aluminiumoxid oder Siliziumkarbid (SiC) aufweisend oder daraus bestehend) aufweisen oder daraus bestehen.

Eine Düse (auch als Emissionsdüse bezeichnet) bezeichnet hierin ein fluidleitendes Bauteil, welches von einer Öffnung (auch als Düsenöffnung bezeichnet) durchdrungen ist, durch welche hindurch der Dampf strömen kann (dann auch als Materialdampfstroms, vereinfacht als Dampfstrom oder allgemeiner als Materialstrom bezeichnet), z.B. in den freien Raum hinaus. Der Materialdampfstrom kann Dampf (d.h. ein gasförmiges Verdampfungsgut) und optional eine oder mehr als eine Verunreinigung (z.B. ein Fluid) aufweisen. Beispiele für die Verunreinigung weisen auf: ein anderes gasförmiges Material, Materialcluster, Tröpfchen oder Ähnliches.

Die Düsenöffnung stellt dem Materialdampfstrom bzw. dem Strömungspfad, entlang dessen der Dampf strömt, eine Verengung bereit, durch welche der Materialstrom hindurch tritt. Vor und/oder nach der Düse kann der Strömungspfad durch eine Querschnittsfläche führen, der größer ist als die Querschnittsfläche der Düsenöffnung. Die Düse kann auf ihrer gesamten Länge die gleiche Querschnittsfläche haben, sich erweitern, verjüngen oder weitere komplexe Formen aufweisen. Die Düse verrichtet keine Arbeit, sondern wandelt zwischen Geschwindigkeit und statischem Druck des Materialstroms. Mittels einer Düse kann der Materialstrom (z.B. das Verdampfungsgut aufweisend) beispielsweise entlang eines Druckgefälles beschleunigt werden.

Gemäß verschiedenen Ausführungsformen kann die Vakuumanordnung eine Transportvorrichtung aufweisen, die eingerichtet ist, das Substrat in der Vakuumkammer und/oder durch diese hindurch zu transportieren (auch als Substrattransportprozess oder kurz als Substrattransport bezeichnet), z.B. entlang eines Transportpfads. Die Transportvorrichtung kann beispielsweise mehrere Rollen (bzw. Walzen) aufweisen, mit denen das transportierte Substrat in Kontakt kommt oder zumindest ein Substratträger, der das transportierte Substrat trägt.

Im Folgenden werden verschiedene Beispiele beschrieben, die sich auf vorangehend Beschriebene und in den Figuren Dargestellte beziehen.

Beispiel 1 ist ein Verfahren, aufweisend: Beschichten eines Substrats (auch als Beschichtungsprozess bezeichnet) mittels eines Materialdampfstroms, der vorzugsweise mittels thermisches Verdampfens eines Verdampfungsguts bereitgestellt wird und/oder von einer Vielzahl von Emissionsdüsen emittiert wird; Überlagern des Materialdampfstroms mit einem Gasstrom (z.B. dessen räumliche Verteilung), vorzugsweise so dass eine räumliche Verteilung des Materialdampfstroms und/oder eine räumliche Verteilung, mit der das Beschichten erfolgt, mittels des Gasstroms beeinflusst wird, wobei der Gasstrom (z.B. dessen räumliche Verteilung) beispielsweise mittels eines Stellglieds bereitgestellt wird, welches gemäß einer Vorgabe angesteuert wird, die optional abgespeichert und/oder zeitinvariant ist.

Beispiel 2 ein Verfahren (beispielsweise gemäß Beispiel 1), aufweisend: Ermitteln einer Angabe (auch als Verteilungsangabe bezeichnet), die eine räumliche Verteilung eines Materialdampfstroms, welcher von einer Vielzahl von Emissionsdüsen emittiert wird, repräsentiert; Ansteuern eines Stellglieds, welches eingerichtet ist, einen Gasstrom (z.B. dessen räumliche Verteilung), der dem Materialdampfstrom überlagert wird, zu beeinflussen, basierend auf der Angabe.

Beispiel 3 ist das Verfahren gemäß Beispiel 2, wobei die Angabe auf einem Resultat eines Beschichtungsprozesses, dem der Materialdampfstrom zugeführt wird (z.B. der mittels des Materialdampfstroms durchgeführt wird), basiert, vorzugsweise auf einer Beschichtung (als Resultat des Beschichtungsprozesses) und/oder deren räumlichen Verteilung, die mittels des Beschichtungsprozesses gebildet wird.

Beispiel 4 ist das Verfahren gemäß Beispiel 2 oder 3, wobei das Resultat des Beschichtungsprozesses sensorisch erfasst wird, vorzugsweise während (z.B. mittels des Materialdampfstroms) der Beschichtungsprozess durchgeführt wird und/oder während dem Beschichtungsprozess der Materialdampfstrom zugeführt wird. Beispielsweise kann Resultat des Beschichtungsprozesses sensorisch erfasst werden außerhalb (auch als ex-situ bezeichnet) des Vakuums (auch als Prozessvakuum bezeichnet), in dem der Beschichtungsprozess durchgeführt wird (z.B. unter erdatmosphärischem Luftdruck), oder in dem Prozessvakuum (auch als in-situ bezeichnet).

Beispiel 5 ist das Verfahren gemäß einem der Beispiele 2 bis 4, wobei das Ansteuern des Stellglieds gemäß einer ersten Vorgabe erfolgt, die auf der Angabe basiert (z.B. darauf basierend ermittelt wird), wobei die erste Vorgabe vorzugsweise eine räumliche Verteilung (dann auch als Soll-Verteilung bezeichnet) des Gasstroms repräsentiert.

Beispiel 6 ist das Verfahren gemäß einem der Beispiele 2 bis 5, wobei das Ermitteln basierend auf einem Substrat erfolgt, nachdem das Substrat mittels des Materialdampfstroms beschichtet wurde, beispielsweise in-situ (z.B. durch Spektroskopie) oder außerhalb des Prozessvakuums (ex-situ).

Beispiel 7 ist das Verfahren gemäß einem der Beispiele 2 bis 6, wobei das Ansteuern zeitabhängig erfolgt und/oder wobei die Angabe zeitabhängig ist.

Beispiel 8 ist das Verfahren gemäß einem der Beispiele 2 bis 7, wobei die Angabe eine Abweichung der räumlichen Verteilung des Materialdampfstroms von einer zweiten Vorgabe (dann auch als Soll-Verteilung bezeichnet) repräsentiert, wobei das Ansteuern eingerichtet ist, der Abweichung entgegenzuwirken.

Beispiel 9 ist das Verfahren gemäß einem der Beispiele 1 bis 8, wobei der Gasstrom auf den Materialdampfstrom zu gerichtet ist und/oder dessen räumliche Verteilung beeinflusse (z.B. diesen streuend oder zumindest teilweise verdrängend). Es kommt beispielsweise zu einer Mischung von Bestandteilen (z.B. einzelne Atome, Moleküle oder andere Teilchen) des Gasstroms und des Materialdampfstroms, in dessen Folge es zu Stößen zwischen den Bestandteilen kommt. Die Stöße begünstigen Streuung des Materialdampfstroms und damit eine Richtungsänderung des Materialdampfstroms. Die unbeeinflusste räumliche Verteilung des Materialdampfstroms kann beispielsweise dem Lambertschen Gesetz folgen und ähnlich sein zu einer Gaußschen Glockenkurve oder, genauer einer Cos-Verteilung, bei der die Dichte des Materials von der Mitte des Materialdampfstroms zum Rand des Materialdampfstroms abnimmt. Auf diese Form der räumlichen Verteilung des Materialdampfstroms nimmt der Gasfluss Einfluss.

Beispiel 10 ist das Verfahren gemäß einem der Beispiele 1 bis 9, wobei der Gasstrom ein Inertgas (welches gegenüber dem Materialdampfstrom inert ist) aufweist, z.B. ein Edelgas.

Beispiel 11 ist das Verfahren gemäß einem der Beispiele 1 bis 10, wobei der Materialdampfstrom ein Material aufweist, das bei Standardbedingungen (d.h. bei einer Temperatur von 293,15 Kelvin und einem Druck von 101325 Pascal) fest ist.

Beispiel 12 ist das Verfahren gemäß einem der Beispiele 1 bis 11, wobei der Gasstrom ein Material aufweist, das bei Standardbedingungen (d.h. bei einer Temperatur von 293,15 Kelvin und einem Druck von 101325 Pascal) gasförmig ist.

Beispiel 13 ist das Verfahren gemäß einem der Beispiele 1 bis 12, wobei die Vielzahl von Emissionsdüsen eingerichtet sind, den Materialdampfstrom mit einer ersten räumlichen Verteilung zu emittieren, wobei der Gasstrom eingerichtet ist, die erste räumliche Verteilung in die zweite räumliche Verteilung zu überführen (mit der beispielsweise das Beschichten erfolgt), wobei vorzugsweise die zweite räumliche Verteilung eine geringere Schwankung (z.B. der Strömungsrate) und/oder eine geringere räumliche Varianz (z.B. räumliche Streuung und/oder Ausbreitung) als die erste räumliche Verteilung aufweist. Beispiel 14 ist das Verfahren gemäß einem der Beispiele 1 bis 13, wobei der Materialdampfstrom mittels thermischen Verdampfens eines Verdampfungsguts bereitgestellt wird.

Beispiel 15 ist das Verfahren gemäß Beispiel 14, wobei die räumliche Verteilung des Gasstroms invariant ist, wenn mittels des Materialdampfstroms ein Beschichtungsprozess durchgeführt wird. Dies stellt anschaulich bereit, dass das Substrat unter zeitlich invarianten Bedingungen beschichtet wird und erhöht somit die Homogenität der Beschichtung.

Beispiel 16 ist ein Computerprogram, das eingerichtet ist, das Verfahren gemäß einem der Beispiele 2 bis 15 durchzuführen.

Beispiel 17 ist ein computerlesbares Medium, das Instruktionen speichert, die eingerichtet sind, wenn von einem Prozessor ausgeführt, den Prozessor dazu zu bringen, das Verfahren gemäß einem der Beispiele 2 bis 15 durchzuführen.

Beispiel 18 ist ein Steuervorrichtung, welche einen oder mehr als einen Prozessor aufweist, die eingerichtet sind, das Verfahren gemäß einem der Beispiele 2 bis 15 durchzuführen.

Beispiel 19 ist eine Dampfverteilungsvorrichtung (z.B. betrieben mittels des Verfahrens gemäß einem der Beispiele 1 bis 15), aufweisend: einen Dampfverteilungskanal, welcher einen Hohlraum aufweist; eine Vielzahl von Emissionsdüsen, welche mittels des Hohlraums miteinander gasleitend gekoppelt sind, zum Emittieren eines Materialdampfstroms aus dem Hohlraum heraus (z.B. mit einer ersten räumlichen Verteilung), mehrere Gasauslässe (z.B. auf den Materialdampfstrom gerichtet) zum Bereitstellen eines dem Materialdampfstrom überlagerten Gasstroms; vorzugsweise ein Stellglied, welches eingerichtet ist, den Gasstrom, beispielsweise dessen räumliche Verteilung, zu beeinflussen; weiter vorzugsweise die Steuervorrichtung gemäß Beispiel 18, welche eingerichtet ist, das Stellglied anzusteuern.

Beispiel 20 ist die Dampfverteilungsvorrichtung gemäß Beispiel 19, wobei die Vielzahl von Emissionsdüsen entlang einer Richtung hintereinander angeordnet ist, wobei die mehreren Gasauslässe entlang der Richtung hintereinander angeordnet sind.

Beispiel 21 ist die Dampfverteilungsvorrichtung gemäß Beispiel 19 oder 20, wobei die mehreren Gasauslässe auf einen Bereich gerichtet sind, zu dem der Materialdampfstrom aus dem Hohlraum heraus emittiert wird.

Beispiel 22 ist die Dampfverteilungsvorrichtung gemäß einem der Beispiele 19 bis 21, ferner aufweisend: eine Heizvorrichtung (welche vorzugsweise thermisch mit dem Dampfverteilungskanal gekoppelt ist und/oder diesen umgibt), welche eingerichtet ist, dem Dampfverteilungskanal und/oder der Vielzahl von Emissionsdüsen thermische Energie zuzuführen. Dies hemmt das Verstopfen der Dampfverteilungsvorrichtung. Vorzugsweise kann die Heizvorrichtung zwischen zumindest einem (d.h. einem oder mehr als einem) der mehreren Gasauslässe und dem Dampfverteilungskanal angeordnet sein. Dies reduziert die thermische Belastung der Gasauslässe.

Beispiel 23 ist die Dampfverteilungsvorrichtung gemäß einem der Beispiele 19 bis 22, wobei die mehreren Gasauslässe zu dem Materialdampfstrom hin gerichtet sind.

Beispiel 24 ist die Dampfverteilungsvorrichtung gemäß einem der Beispiele 19 bis 23, wobei der Dampfverteilungskanal ein Kanalgehäuse und mehrere Öffnungen aufweist, welche das Kanalgehäuse durchdringen und in dem Hohlraum münden; wobei jede Emissionsdüse der Vielzahl von Emissionsdüsen, einen Düsenkopf aufweist, welcher in einer Öffnung der mehreren Öffnungen angeordnet ist. Dies vereinfacht die Konstruktion der Dampfverteilungsvorrichtung.

Beispiel 25 ist eine Vakuumanordnung, aufweisend: die Dampfverteilungsvorrichtung gemäß einem der Beispiele 19 bis 24, und eine Vakuumkammer, in welcher die Dampfverteilungsvorrichtung angeordnet ist, vorzugsweise eine Transportvorrichtung zum Transportieren eines Substrats durch die Vakuumkammer hindurch und/oder an der Dampfverteilungsvorrichtung vorbei.

Beispiel 26 ist eines der Beispiele 1 bis 25, wobei die Emissionsdüsen als Reihe hintereinander angeordnet sind, z.B. entlang einer ersten Richtung, die beispielsweise quer zu einer zweiten Richtung ist, in welche das Substrat transportiert wird (auch als Transportrichtung bezeichnet), und/oder quer zu einer dritten Richtung ist, in welche der Materialdampfstrom emittiert wird (auch als Emissionsrichtung bezeichnet).

Es kann verstanden werden, dass die Angabe einmalig für eine konkrete Konfiguration der Vielzahl von Emissionsdüsen (bzw. der Dampfverteilungsvorrichtung) ermittelt werden kann, und die darauf basierende räumliche Verteilung des Gasstroms (auch als räumliche Gasverteilung bezeichnet) beibehalten wird solange die Konfiguration unverändert bleibt. Die räumliche Verteilung des Gasstroms kann in diesem Fall angepasst sein an die individuelle Dampfverteilungsvorrichtung. Allerdings kann das Ermitteln der Angabe bei Bedarf auch beliebig wiederholt werden, beispielsweise wenn der Verdacht auf Ungenauigkeiten besteht oder wenn der Verdacht auf eine Störung der Konfiguration besteht.

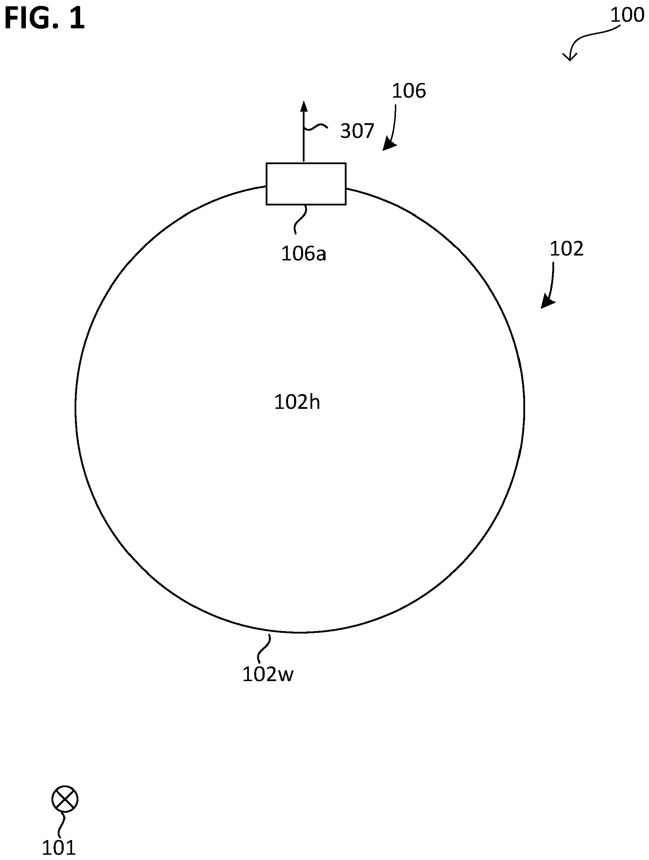

**Fig.1** veranschaulicht eine Dampfverteilungsvorrichtung 100 gemäß verschiedenen Ausführungsformen, z.B. eingerichtet und/oder betrieben gemäß einem der Beispiele 1 bis 25, in einer schematischen Seitenansicht oder Querschnittsansicht, z.B. entlang Richtung 101 (auch als Richtung der Längserstreckung oder als Querrichtung 101 bezeichnet).

Die Dampfverteilungsvorrichtung 100 weist einen Dampfverteilungskanal 102 (auch als kanalförmiger Grundkörper 102 bezeichnet), z.B. ein Rohr, auf, der einen Hohlraum 102h (auch als Dampfraum 102h bezeichnet) aufweist. Der Hohlraum 102h kann sich in den Grundkörper 102 hinein erstrecken (aber nicht zwangsläufig hindurch), z.B. entlang der Querrichtung 101. Der Hohlraum 102h kann beispielsweise auf mindestens vier Seiten von einem Kanalgehäuse 102w (z.B. eine oder mehr als eine Wand aufweisend) des Grundkörpers 102 begrenzt werden. Beispielsweise kann eine Ausdehnung des Hohlraums 102h entlang der Querrichtung 101 mindestens 1 Meter (m) sein, z.B. 2 m oder mehr, oder weniger als 1 m, z.B. in einem Bereich von ungefähr 0,2 m bis ungefähr 1 m (oder 0,5 m), z.B. ungefähr 0,3 m.

Die Dampfverteilungsvorrichtung 100 weist, z.B. pro Hohlraum 102h, eine Vielzahl 106 von Emissionsdüsen 106a (vereinfacht auch als Düse bezeichnet) auf, welche in dem Hohlraum 102h münden und zum Emittieren des Verdampfungsguts (aus dem Hohlraum 102h heraus) in eine Emissionsrichtung 307 eingerichtet sind. Die von jeder dieser Düsen ausgehende Emissionsrichtung 307 kann beispielsweise auf einer planaren Ebene liegen, welche beispielsweise parallel zur Richtung 101 sein kann.

In einer exemplarischen Implementierung kann die Anzahl der Düsen 106a der Vielzahl 106 von Emissionsdüsen, z.B. pro Meter der Ausdehnung des Hohlraums 102h entlang der Querrichtung 101, 5 oder mehr sein, z.B. 10 oder mehr, z.B. 20 oder mehr, z.B. 30 oder mehr, z.B. 40 oder mehr, z.B. 50 oder mehr.

Die Vielzahl 106 von Emissionsdüsen weist, z.B. pro Hohlraum 102h, eine oder mehr als eine Reihe von Emissionsdüsen (auch als Düsenreihe bezeichnet) auf, welche entlang der Querrichtung 101 hintereinander angeordnet sind. Die Vielzahl 106 von Emissionsdüsen sind mittels des Hohlraums 102h fluidleitend miteinander gekoppelt sind. Es kann verstanden werden, dass die Vielzahl 106 von Emissionsdüsen beispielsweise mehrere nebeneinander angeordnete Düsenreihen aufweisen kann (aber nicht zwangsläufig muss), wofür das hierin Beschriebene in Analogie gelten kann.

Generell können die fluidleitend miteinander verbundenen Komponenten der Dampfverteilungsvorrichtung 100 ein hochtemperaturfestes Material aufweisen oder daraus gebildet sein und/oder dasselbe Material aufweisen oder daraus gebildet sein. Dies erreicht, dass der Dampf eines hochtemperaturverdampfenden Materials zuverlässig mittels der Dampfverteilungsvorrichtung 100 verteilt werden kann. Das hochtemperaturfeste Material kann beispielsweise einen Transformationsbereich (z.B. Schmelzpunkt oder Glasübergangstemperatur) in einen viskosen Zustand von mehr als ungefähr 1000°C aufweisen, z.B. mehr als ungefähr 1500°C. Beispiele für das hochtemperaturfeste Material weisen auf: ein Dielektrikum (z.B. Quarzglas aufweisend), eine Keramik (z.B. ein Oxid, ein Nitrid und/oder ein Karbid aufweisend), ein Metall (z.B. Titan). Das hochtemperaturfeste Material kann auch ein Materialgemisch aufweisen bzw. aus mehreren verschiedenen Materialien gebildet sein. Optional kann das hochtemperaturfeste Material chemisch inert sein, z.B. gegenüber Sauerstoff und/oder gegenüber einem verdampften Salz, einem verdampften Perowskit und/oder einer verdampfen Organik.

In einer konkreten Implementierung des Verfahrens 400 wird die Schichtdicke der Beschichtung gemessen, wenn dem Materialdampfstrom kein Gasstrom überlagert wird (anschaulich ohne Gaseinlass). Dann erfolgt ein iteratives Verändern der räumlichen Gasverteilung und Messung der Veränderung der Schichtdicke in Antwort auf das iterative Verändern der räumlichen Gasverteilung. Erfüllt die Schichtdicke ein Kriterium für eine konkrete räumliche Gasverteilung, kann diese räumliche Gasverteilung für alle nachfolgenden Beschichtungsprozesse statisch verwendet werden. Optional kann eine sensorische Erfassung der Schichtdicke erfolgen, während des Beschichtungsprozess. Die Regelung der Gasverteilung kann mittels eines Gasflussreglers erfolgen, dessen Soll-Gasdurchfluss von der Steuervorrichtung vorgegeben werden kann.

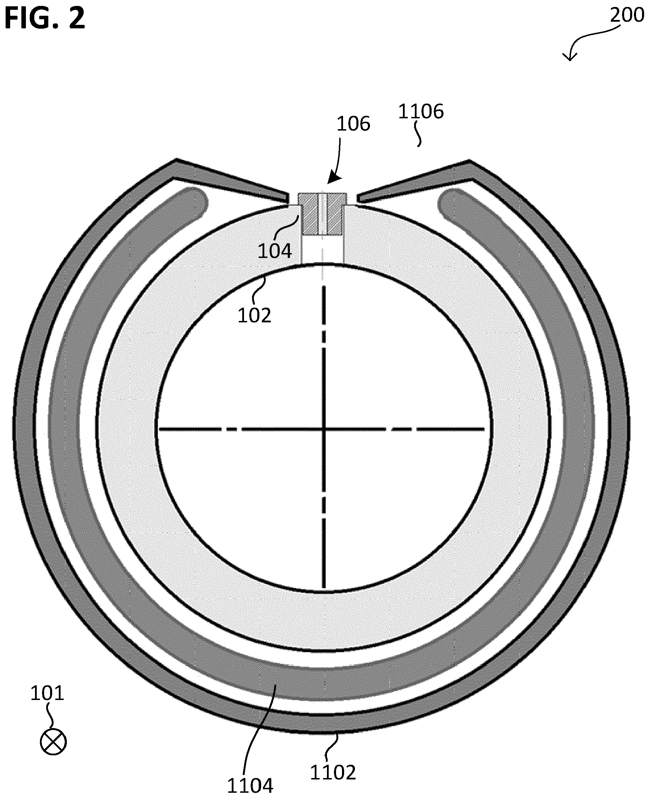

**Fig.2** veranschaulicht eine Dampfverteilungsvorrichtung 100 gemäß verschiedenen Ausführungsformen 200, z.B. eingerichtet und/oder betrieben gemäß einem der Beispiele 1 bis 25, in einer schematischen Seitenansicht oder Querschnittsansicht, wobei die Dampfverteilungsvorrichtung 100 eine Temperiervorrichtung 1102, 1104 aufweist, die zum Zuführen und/oder Entziehen von thermischer Energie eingerichtet ist.

Die Temperiervorrichtung 1102, 1104 kann beispielsweise eine Heizvorrichtung 1104 aufweisen, welche eingerichtet ist, dem Grundkörper 102 thermische Energie zuzuführen. Die Heizvorrichtung 1104 ermöglicht es, den Grundkörper 102 (und/oder den Tiegel) auf eine Temperatur zu bringen, die oberhalb einer Gasübergangstemperatur des Verdampfungsguts ist.

Alternativ oder zusätzlich kann die Temperiervorrichtung 1102, 1104 eine Kühlvorrichtung 1102 (z.B. einen Kühlmantel) aufweisen, welche eingerichtet ist, den Gasauslässen und/oder der Umgebung der Dampfverteilungsvorrichtung 100 thermische Energie zu entziehen und/oder einen Teil der von der Heizvorrichtung 1104 abgegebenen thermischen Energie aufzunehmen. Dies ermöglicht es, die thermische Belastung zu reduzieren.

Die Temperiervorrichtung 1102, 1104 kann den Grundkörper 102 umgeben und pro Düse eine Öffnung 1106 (auch als Durchströmungsöffnung bezeichnet) aufweisen, welche die Düse freilegt. Die Durchströmungsöffnung 1106 kann beispielsweise mit der Aufnahmeöffnung 104 bzw. der Düsenöffnung überlappen. Die Kühlvorrichtung 1102 kann beispielsweise einen Hohlraum aufweisen, welcher im Betrieb von einem Kühlfluid (z.B. Öl oder Wasser) durchflossen werden kann. Die Heizvorrichtung 1104 kann beispielsweise einen resistiven Wandler (z.B. elektrothermischen Wandler) aufweisen, welcher eingerichtet ist, elektrische Energie in thermische Energie umzuwandeln.

Die Heizvorrichtung 1104 kann beispielsweise in einem Spalt zwischen der Kühlvorrichtung 1102 und dem Grundkörper 102 angeordnet sein.

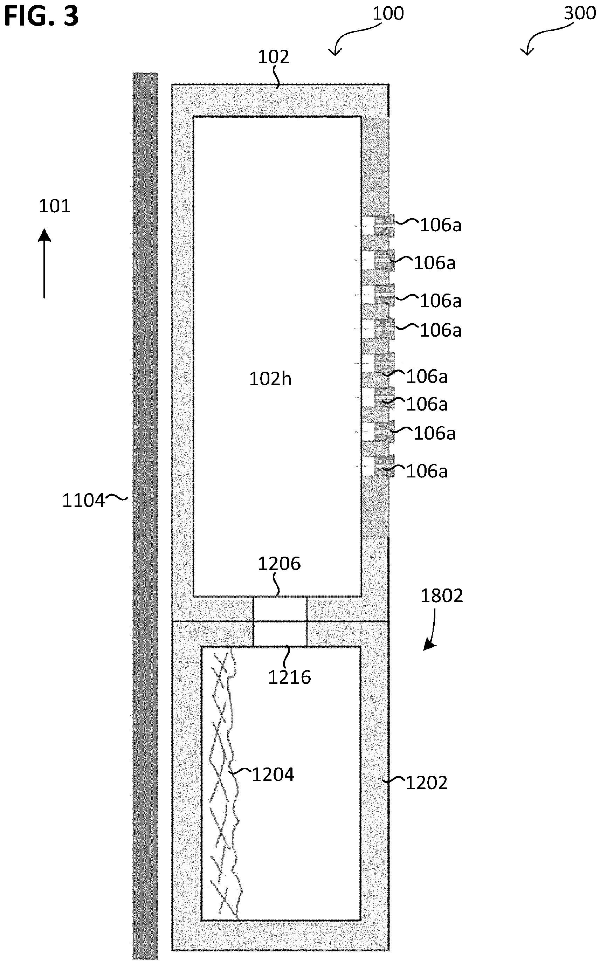

**Fig.3** veranschaulicht eine Verdampfungsvorrichtung 300 (z.B. einen Linearverdampfer) gemäß verschiedenen Ausführungsformen, z.B. eingerichtet und/oder betrieben gemäß einem der Beispiele 1 bis 25, in einer schematischen Querschnittsansicht (mit Blick auf die Querrichtung 101). Die Verdampfungsvorrichtung 300 kann eine Dampfverteilungsvorrichtung 100 aufweisen, z.B. gemäß Ausführungsformen 100 oder 200. Die Verdampfungsvorrichtung 300 kann eine Dampfquelle 1802 aufweisen, welche (z.B. pro Dampfverteilungskanal 102) einen oder mehr als einen Tiegel 1202 aufweist. Jeder Tiegel 1202 kann einen (z.B. geschlossenen oder schließbaren) Behälter aufweisen oder daraus gebildet sein, der (z.B. genau) eine Ausgangsöffnung 1216 aufweist. Der Grundkörper 102 kann eine dazu korrespondierende Eingangsöffnung 1206 aufweisen, welche mit der Ausgangsöffnung 1216 fluidleitend gekoppelt ist, z.B. an diese angrenzend. Diese Kopplung (z.B. mittels der Ausgangsöffnung 1216 und Eingangsöffnung 1206) kann das Innere des Tiegels 1202 mit dem Hohlraum 102h fluidleitend (z.B. gasleitend) verbinden und/oder nach außen abgedichtet sein.

In dem Tiegel 1202 kann im Betrieb ein Verdampfungsgut 1204 angeordnet sein, welches unter Zufuhr thermischer Energie auf eine Temperatur (auch als Gasübergangstemperatur bezeichnet) gebracht werden kann, bei der das Verdampfungsgut 1204 in den gasförmigen Zustand übergeht. Die Gasübergangstemperatur (z.B. Sublimationstemperatur oder Verdampfungstemperatur) kann beispielsweise größer sein als ungefähr 100°C (z.B. in einem Bereich von ungefähr 100°C bis ungefähr 150°C), z.B. als ungefähr 200°C, z.B. als ungefähr 250 °C, z.B. als ungefähr 500°C. Das Zuführen von thermischer Energie kann beispielsweise mittels der Heizvorrichtung 1104 erfolgen.

Das Verdampfungsgut 1204 kann beispielsweise ein organisches Material aufweisen oder daraus gebildet sein oder ein Perowskitmaterial (d.h. ein Material mit einer Gitterstruktur vom Typ des Perowskit) aufweisen oder daraus gebildet sein.

Die hierin erläuterten Verfahren können optional exemplarische Implementierungen zum Betreiben der Dampfverteilungsvorrichtung 100, welche im Einklang mit den Ausführungsformen 300 bis 200 sind, darstellen.

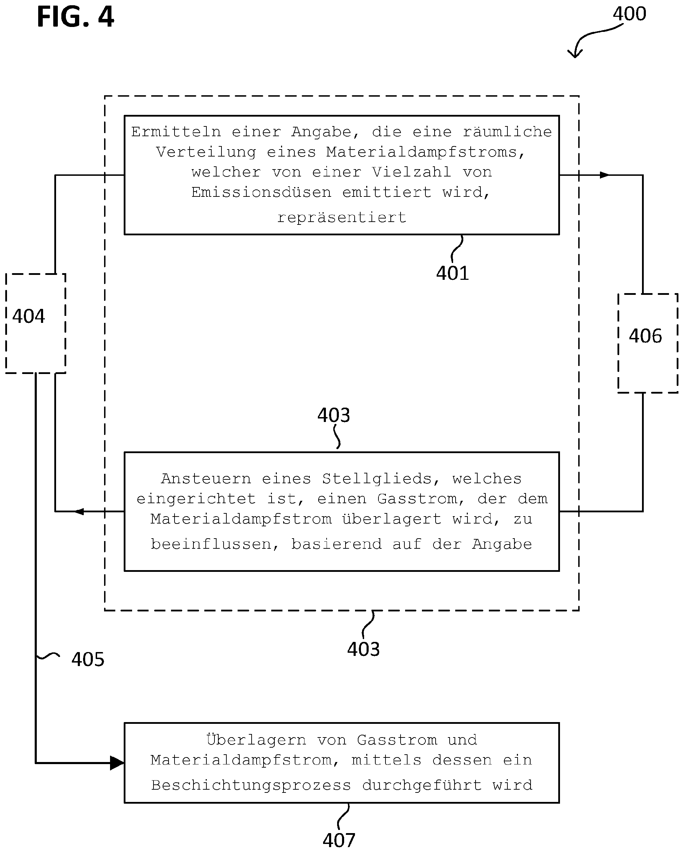

**Fig.4** veranschaulicht ein Verfahren 400 gemäß verschiedenen Ausführungsformen, z.B. eingerichtet und/oder betrieben gemäß einem der Beispiele 1 bis 25, in einem schematischen Ablaufdiagramm. Das Verfahren 400 kann, insofern gewünscht, beispielsweise computerimplementiert 402 sein, was die Automatisierung erleichtert. Die Computerimplementierung kann beispielsweise mittels eines Computerprograms 402, eines computerlesbaren 402 Mediums und/oder einer Steuervorrichtung 402 erfolgen. Das Stellglied 404 ist eingerichtet, den Gasstrom (z.B. dessen räumliche Verteilung), der dem Materialdampfstrom überlagert wird, zu beeinflussen 405, beispielsweise die Überlagerung von Gasstrom und Materialdampfstrom zu beeinflussen.

Beispiele des Stellglieds 404 weisen auf: einen oder mehr als einen Gasflussreglers (z.B. Massendurchflussregler), ein oder mehr als ein Ventil (z.B. Mischventil und/oder Verteilventil), und dergleichen. Das Verteilventil erlaubt es, einen Gaszufluss auf mehrere Gasauslässe aufzuteilen. Der Gasflussregler erlaubt es, den Gaszufluss einzustellen.

In einer ersten exemplarischen Implementierung des Stellglieds 404 (auch als Gasstellglied bezeichnet) kann dieses eingerichtet sein, den Gaszufluss (z.B. als Volumenstrom oder Massenstrom angegeben), der den mehreren Gasauslässen zugeführt wird, zu verändern. In der ersten oder einer zweiten exemplarischen Implementierung des Stellglieds 404 kann dieses eingerichtet sein, eine Verteilung des Gaszuflusses auf die mehreren Gasauslässe zu verändern. Der Gaszufluss kann, einmal eingestellt, während des Beschichtungsprozesses beispielsweise zeitlich invariant sein oder mit einer kleineren Rate (relative Änderung/Zeit) geändert werden, als die Verteilung.

Das Ermitteln der Angabe (auch als Emissionsverteilungsangabe bezeichnet), die eine räumliche Verteilung eines Materialdampfstroms repräsentiert, welcher von der Vielzahl von Emissionsdüsen emittiert wird, kann beispielsweise erfolgen mittels zumindest eines Sensors 406, z.B. mittels eines Messglieds, das den zumindest einen Sensor 406 aufweist. Beispielsweise kann das Ermitteln 401 aufweisen, Messdaten des Sensors 406 in die Emissionsverteilungsangabe zu überführen.

In einer ersten exemplarischen Implementierung wird die räumliche Verteilung der Beschichtung, die mittels des Materialdampfstroms gebildet wird, erfasst, beispielsweise mittels mehrerer Sensoren. Als Messgröße kann beispielsweise die Schichtdicke erfasst werden. Dann kann der oder jeder Sensor des Messglieds beispielsweise ein Schichtdickensensor sein, beispielsweise eingerichtet für eine optische Transmissionsmessung und/oder Ellipsometrie. Als Messgröße kann alternativ oder zusätzlich ein elektrischer Widerstand der Beschichtung erfasst werden. Dann kann das Messglied z.B. einen oder mehr als einen Widerstandsensor aufweisen.

In einer zweiten exemplarischen Implementierung wird die räumliche Verteilung der Emissionsrate (z.B. Menge pro Zeit) und/oder der Richtung, mit welcher der Materialdampfstrom emittiert wird, erfasst, beispielsweise mittels mehrerer Sensoren. Als Messgröße kann beispielsweise die Emissionsrate erfasst werden. Dann kann der oder jeder Sensor beispielsweise ein Ratensensor sein, beispielsweise eingerichtet für eine Ratenmessung.

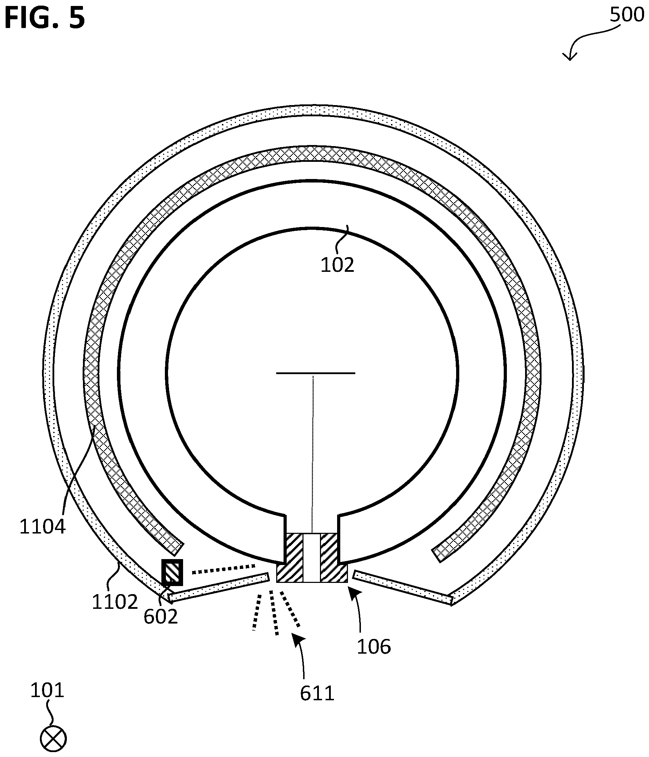

**Fig.5** veranschaulicht eine Dampfverteilungsvorrichtung 100 gemäß verschiedenen Ausführungsformen 500, z.B. eingerichtet und/oder betrieben gemäß einem der Beispiele 1 bis 25, in einer schematischen Querschnittsansicht, mit Blick entlang der Querrichtung 101, in denen die mehreren Gasauslässe zumindest einen (d.h. einen oder mehr als einen) Gasauslass 602 in intern montierter Konfiguration (dann auch als interner Gasauslass 602 bezeichnet) aufweisen (z.B. pro Gasstellgruppe). Jeder interne Gasauslass 602 kann angeordnet sein zwischen dem Grundkörper 102 und einer Komponente der Temperiervorrichtung 1102, 1104, z.B. deren Heizvorrichtung 1104 und/oder Kühlvorrichtung 1102. Diese intern montierte Konfiguration schützt den Gaseinlass vor dem gasförmigen Beschichtungsmaterial (auch als Verdampfungsgut bezeichnet), welches in Emissionsrichtung 307 aus der Vielzahl 106 von Düsen heraus strömt (auch als Materialdampfstrom bezeichnet). Dies vergrößert die Lebensdauer des Gasauslasses 602.

Der von jedem internen Gasauslass 602 emittierte Gasstrom 611 kann durch einen Spalt, der zwischen dem Grundkörper 102 und der Temperiervorrichtung 1102, 1104 gebildet ist, austreten, z.B. in die Durchströmungsöffnung 1106 hinein und/oder auf den Materialdampfstrom zu.

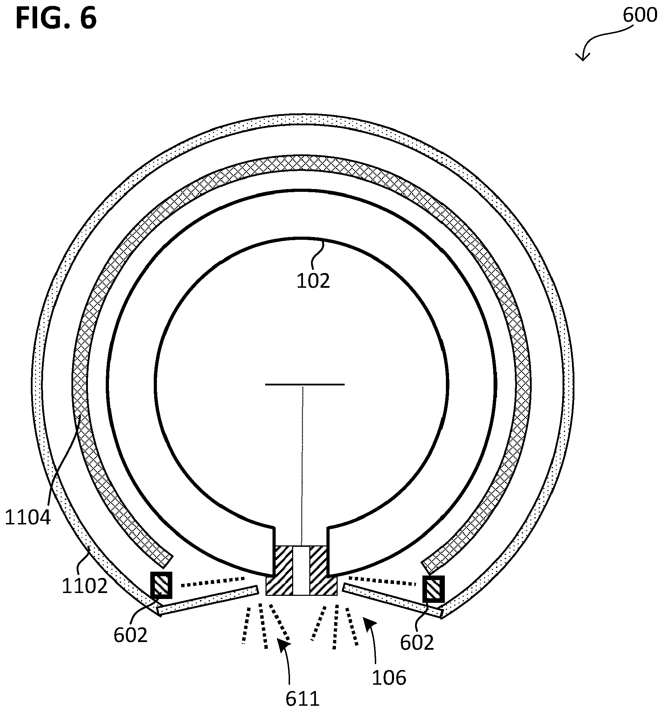

**Fig.6** veranschaulicht eine Dampfverteilungsvorrichtung 100 gemäß verschiedenen Ausführungsformen 600, z.B. eingerichtet und/oder betrieben gemäß einem der Beispiele 1 bis 25, in einer schematischen Querschnittsansicht, mit Blick entlang der Querrichtung 101, in denen die mehreren Gasauslässe zwei interne Gasauslässe 602 aufweisen (z.B. pro Gasstellgruppe), zwischen denen die Vielzahl 106 von Düsen (z.B. Düsenreihe) angeordnet ist. Dies verbessert die Richtungswirkung, mit welcher der Materialdampfstrom beeinflusst wird.

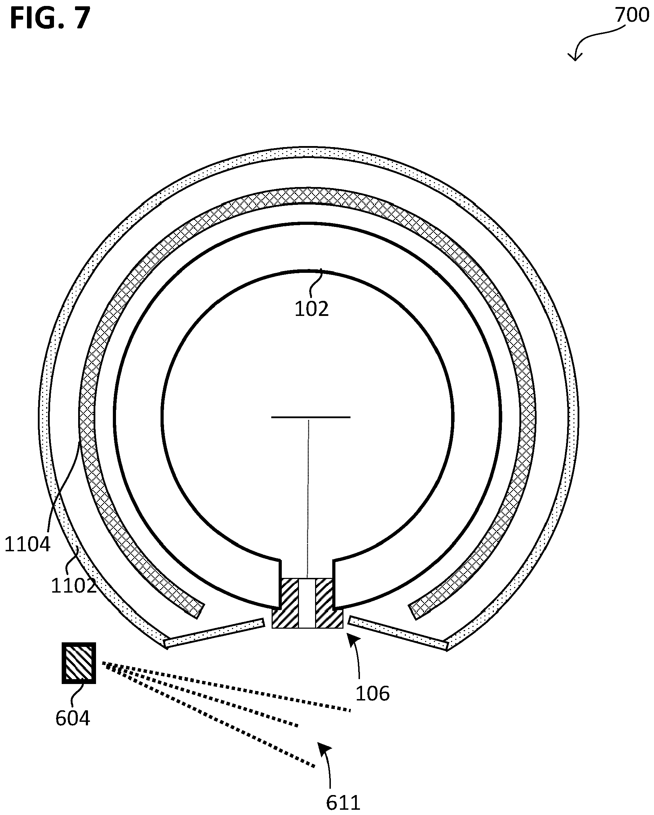

**Fig.7** veranschaulicht eine Dampfverteilungsvorrichtung 100 gemäß verschiedenen Ausführungsformen 700, z.B. eingerichtet und/oder betrieben gemäß einem der Beispiele 1 bis 25, in einer schematischen Querschnittsansicht, mit Blick entlang der Querrichtung 101, in denen die mehreren Gasauslässe zumindest einen Gasauslass 604 in extern montierter Konfiguration (dann auch als externer Gasauslass 604 bezeichnet) aufweisen, beispielsweise alternativ oder zusätzlich zu dem zumindest einen internen Gasauslass 602.

Eine oder jede Komponente der Temperiervorrichtung 1102, 1104, z.B. deren Heizvorrichtung 1104 und/oder Kühlvorrichtung 1102, kann zwischen dem externen Gasauslass 604 und dem Grundkörper 102 angeordnet sein. Diese externe montierte Konfiguration verbessert die Wirkung auf den Materialdampfstrom.

Der von jedem externen Gasauslass 602 emittierte Gasstrom 611 kann an der Temperiervorrichtung 1102, 1104 vorbei und/oder von dieser weg gerichtet sein.

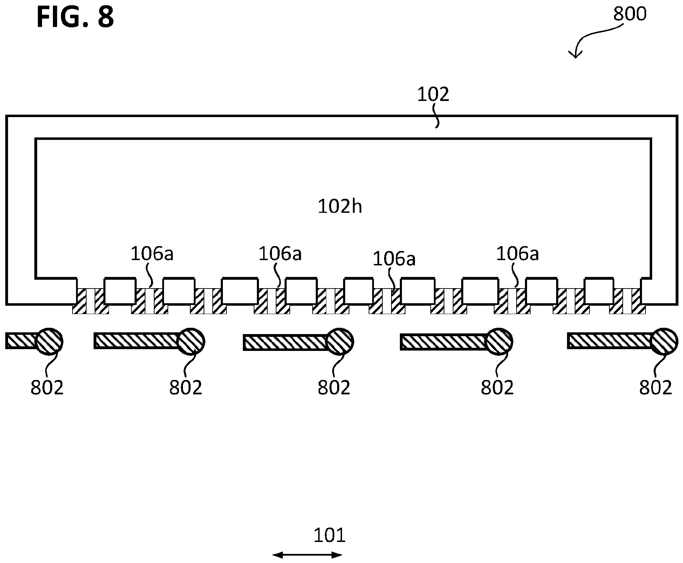

**Fig.8** veranschaulicht eine Dampfverteilungsvorrichtung 100 gemäß verschiedenen Ausführungsformen 800, z.B. eingerichtet und/oder betrieben gemäß einem der Beispiele 1 bis 25, in einer schematischen Querschnittsansicht mit Blickrichtung auf die Querrichtung und/oder entlang der Transportrichtung.

Die Dampfverteilungsvorrichtung 100 weist die mehreren Gasauslässe 802 zum Bereitstellen eines Gasstroms auf, welcher auf dem Materialdampfstrom überlagert wird (z.B. auf diesen gerichtet ist). Die mehreren Gasauslässe 802 können einen oder mehr als einen internen Gasauslass 602 und/oder einen oder mehr als einen externen Gasauslass 604 aufweisen.

Die Dampfverteilungsvorrichtung 100 kann eine oder mehr als eine Gasstellgruppe aufweisen. Jede Gasstellgruppe weist ein Stellglied 404 (auch als Gasstellglied bezeichnet) und einen oder mehr als einen Gasauslass 802 auf, der mittels einer Gasleitung mit dem Gasstellglied 404 der Gasstellgruppe gekoppelt ist. Dies kann derart eingerichtet sein, dass mittels Ansteuerns des Gasstellglieds 404 der Gasstellgruppe der Gaszufluss, der dem einen oder mehr als einen Gasauslass 802 der Gasstellgruppe zugeführt wird, verändert werden kann. Es kann verstanden werden, dass nicht notwendigerweise jeder Gasauslass der mehreren Gasauslässe 802 Teil einer Gasstellgruppe sein muss, aber dies durchaus der Fall sein kann.

Die Anzahl Gasstellgruppen kann gewählt werden basierend auf der Anzahl benötigter Freiheitsgrade im Zustandsraum. In einer wenige komplexen exemplarischen Implementierung weist die Dampfverteilungsvorrichtung zumindest eine Gasstellgruppe auf, die einen erste Gasauslass und einen zweiten Gasauslass aufweist (zwischen denen beispielsweise eine Vielzahl Gasauslässe angeordnet sind), wobei mittels Ansteuerns des Gasstellglieds 404 das Verhältnis, mit dem der Gaszufluss auf den ersten und den zweiten Gasauslass verteilt wird, verändert werden kann. In einer anderen exemplarischen Implementierung weist die Dampfverteilungsvorrichtung zwei Gasstellgruppen auf, die unabhängig voneinander steuerbar sind in dem Gasfluss, den diese aufnehmen und/oder abgeben. In noch einer exemplarischen Implementierung weist die Vielzahl von Emissionsdüsen pro Gasstellgruppe genau maximal eine (viele Freiheitsgrade) Emissionsdüse, maximal zwei oder maximal drei Emissionsdüsen auf. Alternativ oder zusätzlich kann die Anzahl der Gasstellgruppen, z.B. pro Meter dessen Ausdehnung des Hohlraums 102h entlang der Querrichtung 101, 2 oder mehr sein, z.B. 5 oder mehr, z.B. 10 oder mehr, z.B. 20 oder mehr, z.B. 40 oder mehr, z.B. 50 oder mehr.

In einer konkreten exemplarischen Implementierung sind entlang des Dampfverteilungskanals 102 (z.B. ein Rohr), aber außerhalb des Materialdampfstroms (auch als Dampfstrom bezeichnet), mehrere separat regelbare Gaseinlässe 802 angeordnet durch die eine geringe einstellbare Menge Inertgas (z.B. Argon oder Stickstoff) als Gasstrom 611 eingeleitet werden kann.

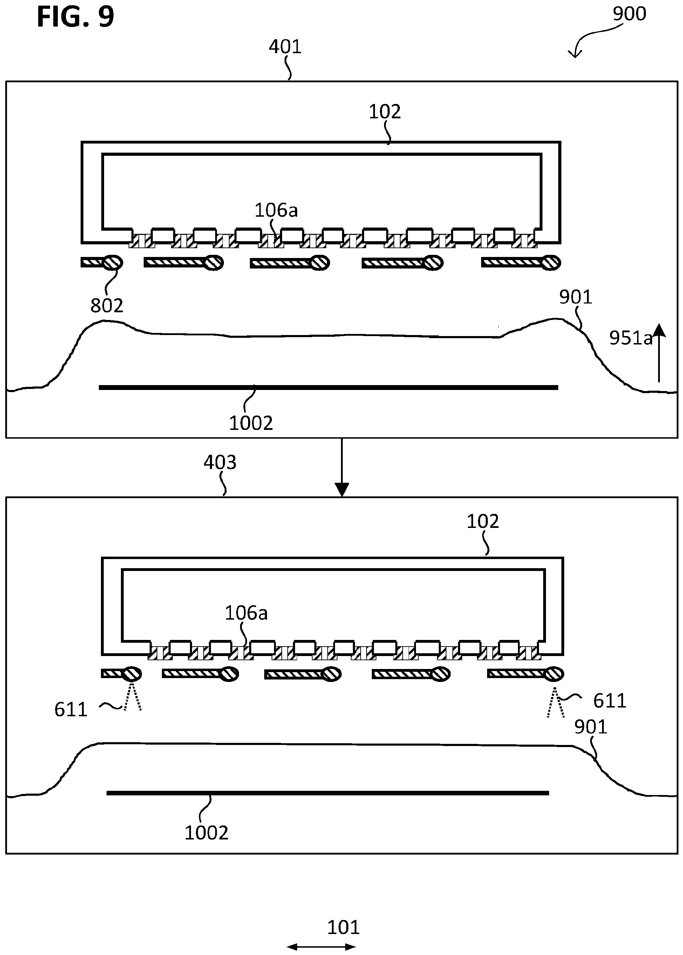

**Fig.9** veranschaulicht das Verfahren 400 gemäß verschiedenen Ausführungsformen 900, z.B. eingerichtet und/oder betrieben gemäß einem der Beispiele 1 bis 25, in einem schematischen Ablaufdiagramm. Das Verfahren 400 kann aufweisen, ein Substrat 1002 durch den Materialdampfstrom hindurch zu transportieren (in die Transportrichtung) und/oder mittels des Materialdampfstroms zu beschichten.

Dargestellt ist die räumliche Verteilung 901 (auch als Materialverteilung 901 bezeichnet) der Materialmenge 951a (entlang der Querrichtung 101), die an dem Substrat 1002 angelagert wird (dann auch als Beschichtungsmaterialverteilung 901 bezeichnet), als exemplarische Verteilungsangabe. Die räumliche Verteilung 901 der Materialmenge korrespondiert zu der räumlichen Verteilung der Dicke einer damit gebildeten Beschichtung auf dem Substrat 1002.

In 401 weist diese räumliche Verteilung 901 der Materialmenge zwei Erhebungen an den Kanten des Substrats 1002 auf.

In 403 wird dem Materialdampfstrom ein Gasstrom 611 überlagert, welcher von einer oder mehr als einer Gasstellgruppe abgegeben wird. Der Gasstrom 611 ist eingerichtet, die Erhebungen abzuflachen, oder zumindest die räumliche Schwankung der räumlichen Materialverteilung 901 zu reduzieren. In dem hier gezeigten Beispiel wird dies erreicht, indem der Gasstrom 611 eine räumliche Verteilung aufweist, die an den Bereichen, an denen die Materialverteilung 901 lokales Maximum aufweist, ebenfalls ein Maximum aufweist.

In einer konkreten exemplarischen Implementierung wird an Stellen mit "zu hoher" Schichtdicke mittels des Gasstroms 611 (z.B. Inertgas) der Druck (lokal) erhöht, was den Materialdampfstrom teilweise verdrängt und/oder streut. Beides reduziert lokal die Schichtdicke, wodurch die Querhomogenität gezielt durch räumliche Gasverteilung eingestellt werden kann.

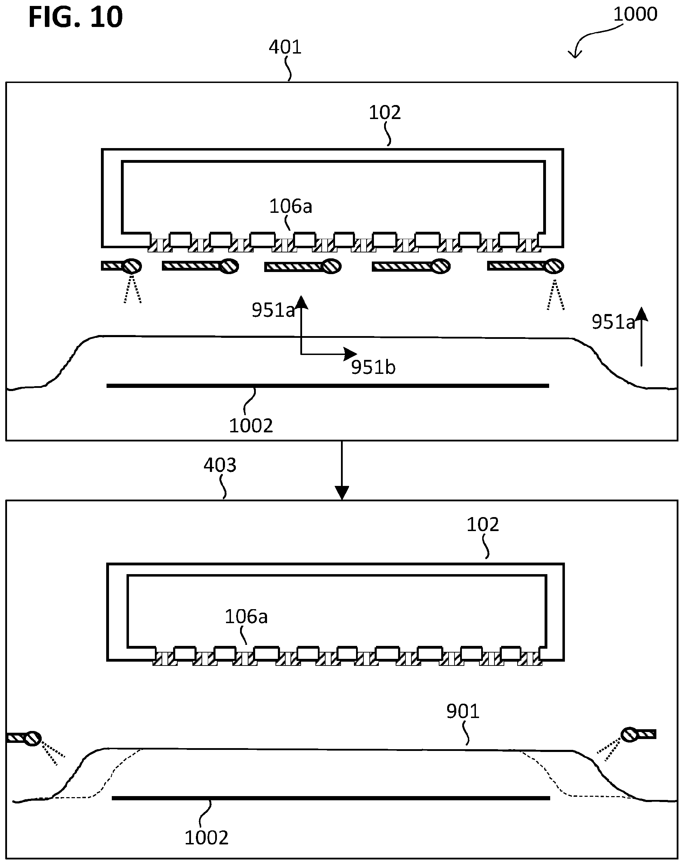

**Fig.10** veranschaulicht das Verfahren 400 gemäß verschiedenen Ausführungsformen 1000, z.B. eingerichtet und/oder betrieben gemäß einem der Beispiele 1 bis 25, in einem schematischen Ablaufdiagramm. Das Verfahren 400 kann aufweisen, ein Substrat 1002 durch den Materialdampfstrom hindurch zu transportieren (in die Transportrichtung) und/oder mittels des Materialdampfstroms zu beschichten.

In 403 wird dem Materialdampfstrom ein Gasstrom 611 überlagert, welcher von einer oder mehr als einer Gasstellgruppe abgegeben wird. Der Gasstrom 611 ist eingerichtet, die Menge des Materialdampfstroms, der an dem Substrat vorbei emittiert wird, zu reduzieren (z.B. dessen räumliche Varianz zu verringern). In dem hier gezeigten Beispiel wird dies erreicht, indem der Gasstrom 611 von einer Stirnseite des Grundkörpers 102 aus zu dem Materialdampfstrom und/oder dem Substrat 1002 hin emittiert wird.

In einer konkreten exemplarischen Implementierung sind stirnseitig (an der Querseite) des Substrates 1002 und/oder des Dampfverteilungskanals 102 beidseitig zwei Gasauslässe 802 installiert. Mittels des Gasstroms 611 wird Material, das sonst neben das Substrat 1002 gelangen würde, auf das Substrat verdrängt und/oder gestreut. Dadurch wird der Materialverlust am Rand reduziert und die Materialeffizienz gesteigert. Optional können die Düsen 106a stirnseitig der Düsenreihe (auch als Randdüsen bezeichnet) angepasst werden, um die Menge an Material, die in den Randbereich gelangt, zu reduzieren.

## Patentansprüche

1. Verfahren (400), aufweisend:
• Ermitteln (401) einer Angabe, die eine räumliche Verteilung eines Materialdampfstroms, welcher von einer Vielzahl von Emissionsdüsen (106a) emittiert wird, repräsentiert;
• Ansteuern (403) eines Stellglieds (404), welches eingerichtet ist, einen Gasstrom (611), der dem Materialdampfstrom überlagert wird, zu beeinflussen, basierend auf der Angabe.

2. Verfahren (400) gemäß Anspruch 1, wobei die Angabe auf einem Resultat eines Beschichtungsprozesses, dem der Materialdampfstrom zugeführt wird, basiert.

3. Verfahren (400) gemäß Anspruch 2, wobei das Resultat des Beschichtungsprozesses sensorisch erfasst wird während dem Beschichtungsprozess der Materialdampfstrom zugeführt wird.

4. Verfahren (400) gemäß einem der Ansprüche 1 bis 3, wobei das Ansteuern des Stellglieds (404) gemäß einer ersten Vorgabe erfolgt, die auf der Angabe basiert, wobei die erste Vorgabe eine räumliche Soll-Verteilung des Gasstroms (611) repräsentiert.

5. Verfahren (400) gemäß einem der Ansprüche 1 bis 4, wobei die Angabe eine Abweichung der räumlichen Verteilung des Materialdampfstroms von einer zweiten Vorgabe repräsentiert, wobei das Ansteuern eingerichtet ist, der Abweichung entgegenzuwirken.

6. Verfahren (400) gemäß einem der Ansprüche 1 bis 5, wobei das Ermitteln basierend auf einem Substrat erfolgt, nachdem das Substrat mittels des Materialdampfstroms beschichtet wurde.

7. Verfahren (400) gemäß einem der Ansprüche 1 bis 6, wobei das Ansteuern zeitabhängig erfolgt und/oder wobei die Angabe zeitabhängig ist.

8. Verfahren (400) gemäß einem der Ansprüche 1 bis 7, wobei der Gasstrom auf den Materialdampfstrom zu gerichtet ist und/oder dessen räumliche Verteilung beeinflusst, vorzugsweise diesen streuend oder zumindest teilweise verdrängend.

9. Computerprogram, das eingerichtet ist, das Verfahren (400) gemäß einem der Ansprüche 1 bis 8 durchzuführen.

10. computerlesbares Medium, das Instruktionen speichert, die eingerichtet sind, wenn von einem Prozessor ausgeführt, den Prozessor dazu zu bringen, das Verfahren (400) gemäß einem der Ansprüche 1 bis 8 durchzuführen.

11. Steuervorrichtung, welche einen oder mehr als einen Prozessor aufweist, der eingerichtet ist, das Verfahren (400) gemäß einem der Ansprüche 1 bis 8 durchzuführen.

12. Dampfverteilungsvorrichtung (100), aufweisend:
• einen Dampfverteilungskanal (102), welcher einen Hohlraum (102h) aufweist;
• eine Vielzahl (106) von Emissionsdüsen (106a), welche mittels des Hohlraums (102h) miteinander gasleitend gekoppelt sind, zum Emittieren eines Materialdampfstroms aus dem Hohlraum (102h) heraus,
• mehrere Gasauslässe (108) zum Bereitstellen eines dem Materialdampfstrom überlagerten Gasstroms (611).

13. Dampfverteilungsvorrichtung (100) gemäß Anspruch 12, wobei die Vielzahl (106) von Emissionsdüsen (106a) entlang einer Richtung (101) hintereinander angeordnet ist, wobei die mehreren Gasauslässe (108) entlang der Richtung (101) hintereinander angeordnet sind.

14. Dampfverteilungsvorrichtung (100) gemäß Anspruch 12 oder 13, wobei die mehreren Gasauslässe (106a) auf einen Bereich gerichtet sind, zu dem der Materialdampfstrom aus dem Hohlraum (102h) heraus emittiert wird.

15. Verfahren (400), aufweisend:
• Beschichten eines Substrats (1002) mittels eines Materialdampfstroms, der von einer Vielzahl (106) von Emissionsdüsen (106a) emittiert wird;
• Überlagern (407) des Materialdampfstroms mit einem Gasstrom (611), so dass eine räumliche Verteilung des Materialdampfstroms mittels des Gasstroms (611) beeinflusst wird.
